# EUROPEAN PATENT APPLICATION

(11) **EP 2 683 044 A1**
(43) Date of publication of application: **08.01.2014**
(21) Application number: 12751804.1
(22) Date of filing: 22.02.2012
(51) Int. Cl.: H02G 3/04, H01B 7/17, H05K 9/00

(54) **PROTECTIVE IMPLEMENT, METHOD OF MANUFACTURING SAME, AND SHIELDED CONDUCTOR**

(30) Priority: 28.02.2011 JP 2011041373
(71) Applicant: AutoNetworks Technologies, Ltd., Yokkaichi-shi, Mie 510-8503 (JP); Sumitomo Wiring Systems, Ltd., Yokkaichi-shi, Mie 510-8503 (JP); Sumitomo Electric Industries, Ltd., Chuo-ku Osaka-shi Osaka 541-0041 (JP)
(72) Inventor: AOYAMA Naoki, Yokkaichi-shi Mie 510-8503 (JP); KUWAHARA Masanori, Yokkaichi-shi Mie 510-8503 (JP); SONODA Fujio, Yokkaichi-shi Mie 510-8503 (JP); ITANI Yasushi, Yokkaichi-shi Mie 510-8503 (JP); SUGIMOTO Yoshinori, Yokkaichi-shi Mie 510-8503 (JP); IZAWA Katsutoshi, Yokkaichi-shi Mie 510-8503 (JP)
(74) Representative: Winter, Brandl, Fürniss, Hübner, Röss, Kaiser, Polte - Partnerschaft
(86) International application number: PCT/JP2012/054212
(87) International publication number: WO 2012/117907

(57) **Abstract**

A protector 20 is configured to protect a portion of an electric wire 11 that is surrounded by a metal pipe 15 and connected to a device provided in a casing 16. The protector 20 protects the portion of the electric wire 11 extending from an end portion of the metal pipe 15 to an end portion of the casing 16. The protector 20 includes a tubular outer layer member 21, a tubular flexible shield member 23, a first fixing member 30A, and a second fixing member 30B. The outer layer member 21 is made of flexible insulation and arranged to extend from the end portion of the metal pipe 15 to the end portion of the casing 16. The shield member 23 is arranged along an inner surface of the outer layer member 21 and provided integrally with the outer layer member 21. The shield member 23 is made of a conductive material. The first fixing member 30A is connected to a first connecting portion 23A of an inner surface of the shield member 23 to which the metal pipe 15 is to be connected. The second fixing member 30B is connected to a second connecting portion 23B of the inner surface of the shield member 23 to which the casing 16 is to be connected.

## Description

### TECHNICAL FIELD

The present invention relates to a protector, a method of manufacturing the protector, and a shield conductor.

### BACKGROUND ART

A shield conductor is mounted in a vehicle such as an electric vehicle and a hybrid vehicle to interconnect devices such as an inverter, a motor, and a battery. Such a shield conductor generally includes an electric wire and a shield member that covers a periphery of the electric wire. The electric wire is electrically connected to an equipment such as a connecting terminal provided in a casing. The shield member is electrically connected to the conductive casing at the end of the shield conductor.

Such a shield conductor may include a protector that protects the electric wire and the shield member together with a connecting portion connected to the casing (refer to Patent Document 1). The protector described in Patent Document 1 is a tubular member made of rubber. The tubular member is arranged outside the shield member that covers the periphery of the electric wire. An end portion of the tubular member covers a part of the casing.

In the shield conductor in Patent Document 1, the shield member is provided to the electric wire to block electromagnetic wave generating from the electric wire. The protector is provided to protect the electric wire and the shield member.

The shield conductor in Patent Document 1 includes a tubular braided wire that is made by interweaving metal wires in mesh. The braided wire is provided as the shield member. The end of such a braided wire may be connected to a metal pipe that blocks electromagnetic wave generating from the electric wire and protects the electric wire (refer to Patent Document 2).

### RELATED ART DOCUMENT

### Patent Document

Patent Document 1: Japanese Unexamined Patent Publication No. 2006-313698
Patent Document 2: Japanese Unexamined Patent Publication No. 2004-171952

### DISCLOSURE OF THE PRESENT INVENTION

### Problem to be Solved by the Invention

In the above-described shield conductor, the braided wire, the metal pipe, and the protector need to be attached to the electric wire in this sequence in the attachment work of the members for the electromagnetic shielding and the wire protection. Further, a clamp member is necessary to be fixed to a connecting portion between the metal pipe and the braided wire from the outer side. This attachment work is troublesome in the conventional shield conductor.

The present invention was accomplished in view of the foregoing circumstances. An object of the present invention is to provide a protector that simplifies attachment of electromagnetic shielding and wire protection members, and to provide a shield conductor including such a protector.

### Means for Solving the Problem

To solve the above problem, a tubular protector according to the present invention protects an electric wire that is surrounded by a metal pipe and connected to a device provided in a casing. The protector protects a portion of the electric wire extending from an end portion of the metal pipe to an end portion of the casing. The protector includes a tubular outer layer member, a tubular flexible shield member, and one or more fixing members selected from a first fixing member and a second fixing member. The outer layer member is made of flexible insulation and arranged to extend from the end portion of the metal pipe to the end portion of the casing. The shield member is arranged along an inner surface of the outer layer member and provided integrally with the outer layer member. The shield member is made of a conductive material and configured to be electrically connected to the metal pipe and the casing. The first fixing member is connected to a first connecting portion of an inner surface of the shield member to which the metal pipe is to be connected. The first fixing member is configured to fix the protector and the metal pipe and to establish electrical connection therebetween. The second fixing member is connected to a second connecting portion of the inner surface of the shield member to which the casing is to be connected. The second fixing member is configured to fix the protector and the casing and to establish electrical connection therebetween.

Further, a shield conductor according to the present invention includes the above protector, an electric wire configured to be connected to a device provided in a casing, and a metal pipe surrounding the electric wire.

According to the present invention, electromagnetic shielding and electric wire protection members are attached as follows. First, the protector according to this invention is attached to the end portion of the metal pipe. Next, the electric wire is inserted through the metal pipe and then connected to the device housed in the casing. Then, the protector is fitted over the end portion of the casing to which the electric wire is connected. Consequently, the protector is arranged across the portion from the end portion of the metal pipe to the end portion of the casing.

According to the present invention, the protector includes the tubular outer layer member, the tubular flexible shield member, and one or more fixing members selected from the first fixing member and the second fixing member. The tubular outer layer member is made of flexible insulation and arranged to extend from the end portion of the metal pipe to the end portion of the casing and the outer layer member. The shield member is arranged along the inner surface of the outer layer member and provided integrally with the outer layer member. The shield member is made of a conductive material and electrically connected to the metal pipe and the casing. The first fixing member is connected to a connecting portion of inner surface of the shield member to which the metal pipe is connected (the first connecting portion). The second fixing member is connected to a connecting portion of inner surface of the shield member to which the casing is connected (the second connecting portion). Namely, according to the present invention, after the protector is arranged to extend from the end portion of the metal pipe to the end portion of the casing, the portion of the protector to which the fixing member is connected is fixed with using a jig. With this simple operation, the protector can be firmly fixed to one or more members selected from the metal pipe and the casing. Further, the electric wire including the connecting portion connected to the device can be protected. Furthermore, the shield member, which is made of a conductive material and provided integrally with the inner surface of the outer layer member of the protector, is directly connected to the metal pipe and the casing or connected to the metal pipe and the casing via the respective fixing members, and this ensures each connection. Further, according to the present invention, the protector and the fixing members are connected to each other and provided as a single member. This can reduce the number of parts.

According to the present invention, a work of attaching a member for the electromagnetic shielding and electric wire protection can be simplified.

The present invention may have a following configuration.

The shield conductor may further include a tubular inner layer member made of flexible insulation. The inner layer member is provided on an inner surface of the shield member excluding parts of the inner surface of the shield member corresponding to the first connecting portion and the second connecting portion. The inner layer member and the outer layer member sandwich the shield member so as to be integral with each other.

With this configuration, because the shield member is less likely to catch on the electric wire or a terminal connected to the electric wire. Therefore, the protector can be easily attached and the inner surface of the shield member can be protected.

The outer layer member may be made of rubber. With this configuration, the first connecting portion is pressed to the end portion of the metal pipe due to the elasticity of the outer layer member and the electrical connection between the shield member and the metal pipe can be secured. The second connecting portion is pressed to the end portion of the casing due to the elasticity of the outer layer member and the electrical connection between the shield member and the casing can be secured.

The inner layer member may be made of rubber. With this configuration, the connection between the protector and the metal pipe and between the protector and the casing can be secured.

To solve the above problem, the present invention is a method of manufacturing a tubular protector protects an electric wire that is surrounded by a metal pipe and connected to a device provided in a casing. The protector protects a portion of the electric wire extends from an end portion of the metal pipe to an end portion of the casing. The method includes: connecting fixing a member to one or more portions selected from a first connecting portion and a second connecting portion of an inner surface of a tubular shield member, the fixing member having conductivity and being configured to fix the protector to one or more members selected from the metal pipe and the casing, the shield member having flexibility and being made of a conductive material, the first connecting portion being configured to be electrically connected to the metal pipe, the second connecting portion being configured to be electrically connected to the casing; and forming an outer layer member on an outer surface of the shield member, the outer layer member being made of an insulation material.

The present invention is a shield conductor including the protector obtained by the above manufacturing method, the electric wire configured to be connected to the device provided in the casing, and the metal pipe surrounding the electric wire.

The method of manufacturing the protector of the present invention includes: connecting a fixing member to one or more portions selected from a first connecting portion and a second connecting portion of an inner surface of a tubular shield member, the fixing member having conductivity and being configured to fix the protector to one or more members selected from the metal pipe and the casing, the first connecting portion being configured to be electrically connected to the metal pipe, the second connecting portion being configured to be electrically connected to the casing; and forming an outer layer member on an outer surface of the shield member, the outer layer member being made of an insulation material.

If the outer layer member is formed before connecting the fixing members to the inner surface of the shield member, insulation member made of an insulation material may be formed portions of the inner surface of the shield member corresponding to the first connecting portion and the second connecting portion. In this case, a method like masking the portion corresponding to the first and the second connecting portions is necessary. However, according to the present invention, because the fixing members are connected to the predetermined portion of the inner surface of the shield member and then the outer layer member is formed, such a masking treatment is not necessary. Thus, the protector of the present invention can be easily manufactured.

The method for manufacturing the present invention may have a following configuration.

The method of manufacturing the protector may further include forming an inner layer member along a part of the inner surface of the shield member excluding the first and the second connecting portions, the inner layer member being made of an insulation material.

With such a configuration, because the inner layer member is formed the inner surface of the shield member, the shield member is less likely to catch on the electric wire or a terminal connected to the electric wire. Therefore, the protector can be easily attached and the inner surface of the shield member can be protected.

The outer layer member may be formed with rubber. With this configuration, the first connecting portion is pressed to end portion of the metal pipe due to the elasticity of and the connection between the shield member and the metal pipe can be secured. The second connecting portion is pressed to end portion of the casing due to the elasticity of and the connection between the shield member and the casing can be secured.

The inner layer member may be formed with rubber. With this configuration, the connection between the protector and the metal pipe and between the protector and the casing can be more secured.

### Advantageous Effect of the Invention

The present invention provides a protector that simplifies a work of attaching members for electromagnetic shielding and electric wire protection, and to provide a shield conductor including such a protector.

### BRIEF DESCRIPTION OF THE DRAWINGS

FIG. 1 is a side view of a shield conductor according to a first embodiment.
FIG. 2 is a cross-sectional view taken along line X-X in FIG. 1.
FIG. 3 is a cross-sectional view of the shield conductor.
FIG. 4 is a perspective view of a fixing member.
FIG. 5 is a side view of the shield conductor before a protector is fixed to a metal pipe.
FIG. 6 is a cross-sectional view taken along line Y-Y in FIG. 5.
FIG. 7 is a cross-sectional view of the shield conductor after the protector is attached to the metal pipe, and before the fixing member is fixed.
FIG. 8 is a cross-sectional view of a shield conductor explained in another embodiment (1).
FIG. 9 is a cross-sectional view of a shield conductor explained in other embodiment (2).
FIG. 10 is a cross-sectional view of the shield conductor before the fixing member is fixed.

### MODE FOR CARRYING OUT THE INVENTION

### <First embodiment>

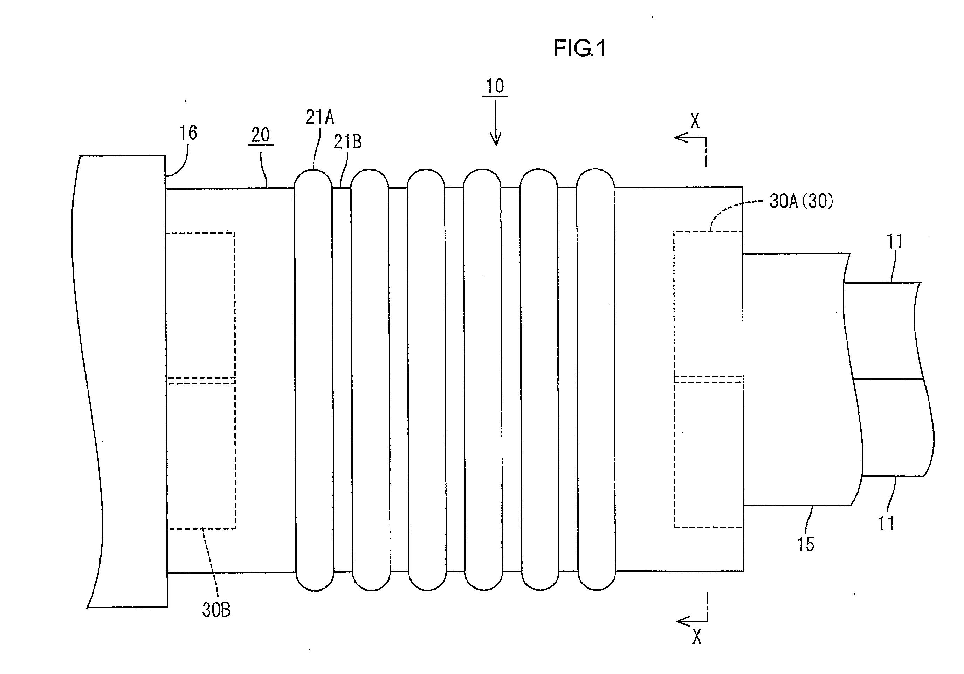

A first embodiment of the present invention will be described with reference to FIGS. 1 to 7. As illustrated in FIG. 1, a shield conductor 10 in this embodiment includes electric wires 11, a metal pipe 15, and a tubular protector 20. The electric wires 11 are connected to a device (not illustrated) housed in a casing 16 of an electric component. The metal pipe 15 covers peripheries of the electric wires 11. The protector 20 covers a portion of the electric wires 11 extending from an end portion of the pipe 15 to an end portion of the casing 16 when the protector 20 is connected to the casing 16.

Because the electric wires 11 are surrounded by the metal pipe 15 and the protector 20, electromagnetic waves from the electric wires 11 are shielded. The shield conductor 10 is installed in a vehicle such as an electric vehicle and a hybrid vehicle (not illustrated) to interconnect electric components such as a battery (not illustrated), an inverter (not illustrated), and a motor (not illustrated).

### (Electric wire 11)

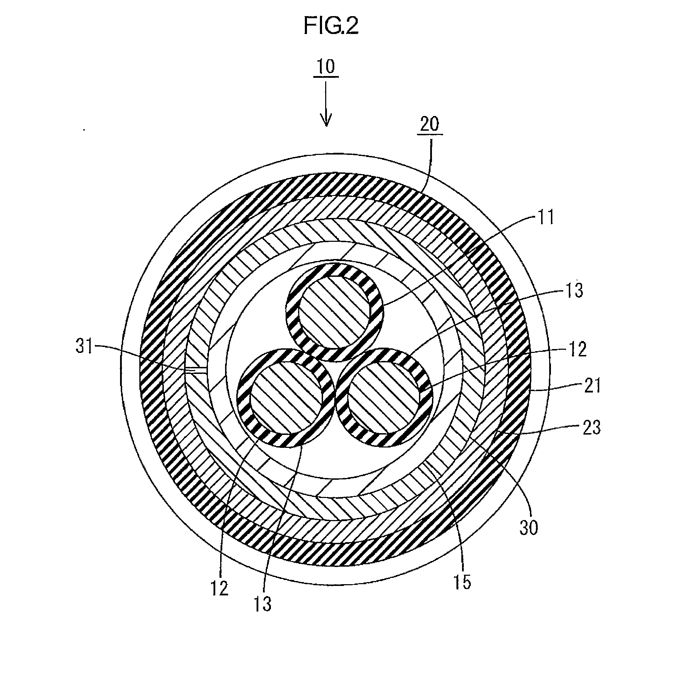

As illustrated in FIG. 2, three electric wires 11 are passed through inside the metal pipe 15 and inside the protector 20 and arranged in a triangle (the electric wires 11 are arranged such that lines connecting the centers of the electric wires 11 form a substantially regular triangle). Each electric wire 11 includes a core wire 12 and wire insulation 13. The core wire 12 has a circular cross-sectional shape and is made of metal (e.g. copper, copper alloy, aluminum, aluminum alloy, stainless). The wire insulation 13 covers an outer periphery of the core wire 12. The core wire 12 may be a rod-shaped single core wire or may be a stranded wire made of a plurality of metal thin wires that are twisted one another. A terminal connector, which will not be explained in detail, is provided at an end of the electric wire 11 and electrically connected to the device provided in the casing 16. The casing 16 is made of metal (conductor) such as aluminum and stainless.

### (Metal pipe 15)

As illustrated in FIG. 2, the metal pipe 15 has a circular cross-sectional shape and has a constant thickness over its entire circumference. Namely, an inner circumference and an outer circumference of the metal pipe 15 are concentric circles. An outer surface of the metal pipe 15 is smooth and arc surface.

The metal pipe 15 can be made of any metal such as aluminum, aluminum alloy, iron, stainless, copper, and copper alloy as necessary. The metal pipe 15 is made of aluminum or aluminum alloy in this embodiment. If the metal pipe 15 is made of iron, an antirust process may be applied to an inner surface and the outer surface of the metal pipe 15. Any antirust process such as galvanization and film coating may be applied as necessary.

### (Protector 20)

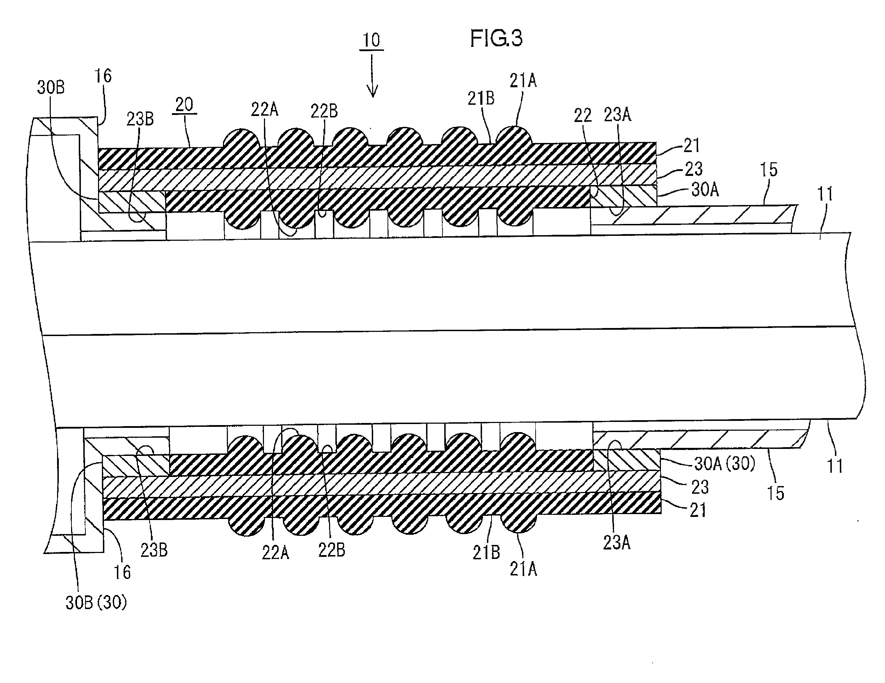

As illustrated in FIG. 3, the protector 20 is arranged to cover the portion of the electric wires 11 extending from the end portion of the metal pipe 15 to the end portion of the casing 16. The protector 20 includes an outer layer member 21, an inner layer member 22, a shield member 23, and fixing members 30. The outer layer member 21 configures an outer surface of the protector 20. The inner layer member 22 configures an inner surface of the protector 20. The shield member 23 is provided between the outer layer member 21 and the inner layer member 22. Each fixing member 30 is connected to the shield member 23.

Each of the outer layer member 21 and the inner layer member 22 is formed in a tubular shape and is made of rubber such as fluorine-contained rubber, silicone rubber, and acrylic rubber.

The outer layer member 21 is arranged such that one end portion (a right end portion in FIG. 3) of the outer layer member 21 overlaps the end portion of the metal pipe 15 and another end portion (a left end portion in FIG. 3) of the outer layer member 21 overlaps the end portion of the casing 16. The outer layer member 21 has an outer surface between the one end portion and the other end portion that is formed in a wavy shape. Namely, projection portions 21A and recess portions 21B are formed alternately and repeatedly. With such a configuration, the outer layer member 21 is easily bent.

The shield member 23 is configured with a braided wire that is made by interweaving metal wires in mesh. The shield member 23 has one end portion 23A (a right end portion 23A in FIG. 3) and another end portion 23B (a left end portion 23B in FIG. 3). The one end portion 23A is fitted to the metal pipe 15 together with the outer layer member 21 from an outer side and electrically connected to the metal pipe 15. The other end portion 23B is fitted to the casing 16 together with the outer layer member 21 from the outer side and electrically connected to the casing 16. The one end portion 23A of the shield member 23 that is connected to the metal pipe 15 is a first connecting portion 23A. The other end portion 23B of the shield member 23 that is connected to the casing 16 is a second connecting portion 23B. The shield member 23 that is configured with the braided wire has high flexibility that enables any deformations such as bending with curving, stretching in a longitudinal direction, and changes in a diameter.

The metal wires of the shield member 23 may be made of any one of aluminum, aluminum alloy, iron, stainless, copper, and copper alloy as necessary. In this embodiment, copper or copper alloy is used. A plated layer may be applied to a surface of the metal wire. The plated layer may be configured with any metal such as tin, nickel, chromium as necessary. The shield member 23 may also be a tubular conductive film made of copper or aluminum.

As illustrated in FIG. 3, the inner layer member 22 is provided in a tubular shape and along a part of an inner surface of the shield member 23 excluding the first connecting portion 23A, at which the outer layer member 21 and the shield member 23 are connected to the metal pipe 15, and the second connecting portion 23B, at which the outer layer member 21 and the shield member 23 are connected to the casing 16. Similar to the outer layer member 21, the inner surface of the inner layer member 22 is formed in a wavy shape and projection portions 22A and recess portions 21B are formed alternately and repeatedly.

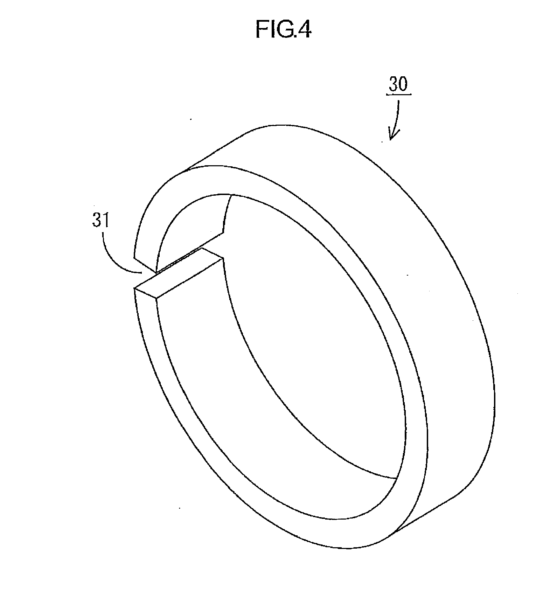

In this embodiment, the fixing members 30 that fix the protector 20 to the metal pipe 20 and to the casing 16 are connected to the first and the second connecting portions 23A and 23B of the shield member 23, respectively. As illustrated in FIG. 4, each fixing member 30 in the present embodiment is a C-ring 30 that is configured with a conductive metal board formed into a C-shape.

As illustrated in FIG. 3, the C-rings 30 are connected to the inner surface of the shield member 23. More specifically, one of the C-rings 30 is connected to the first connecting portion 23A in the protector 20 and the other one of the C-rings 30 is connected to the second connecting portion 23B in the protector 20. The one C-ring 30 that is connected to the first connecting portion 23A is a first C-ring 30A and the other C-ring 30B that is connected to the second connecting portion 23B is a second C-ring 70B. The first and the second C-rings 30A and 30B are collectively referred to as the C-rings 30.

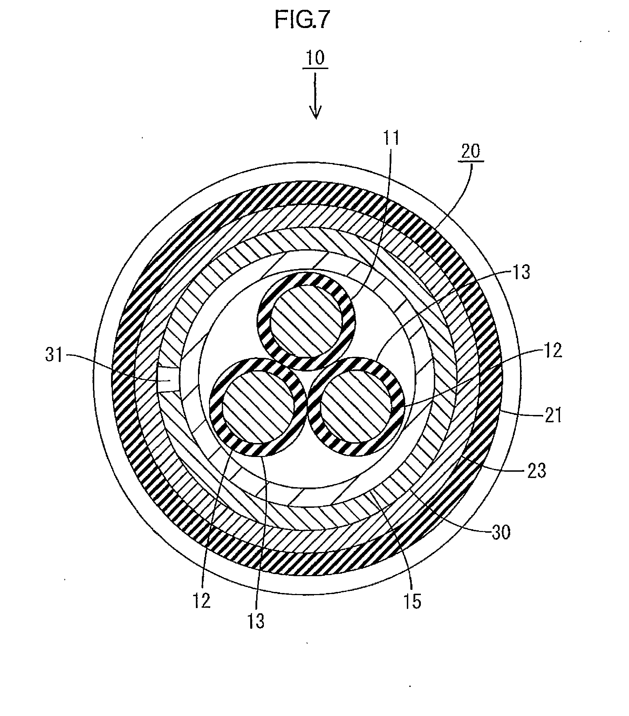

In the this embodiment, the shield conductor 10 is electrically connected to the metal pipe 15 via the first C-ring 30A at the first connecting portion 23A and is electrically connected to the casing 16 via the second C-ring 30B at the second connecting portion 23B. After the protector 20 is fitted to the metal pipe 15 and the casing 16, the first and the second connecting portions 23A and 23B are clamped. As a result, diameters of the C-rings 30A and 30B are decreased (gaps 31 of the C-rings 30A and 30B are decreased) and thus the protector 20 is firmly fitted to the metal pipe 15 and the casing 16 (refer to FIG. 7 that illustrates the C-ring 30 before the clamping and FIG. 2 that illustrates the C-ring 30 after the clamping).

### (a method of manufacturing the shield conductor 10)

A method of manufacturing the shield conductor 10 according to the present embodiment will be explained hereinafter. The method of manufacturing the shield conductor 10 is not limited to the following method.

First, the first and second C-rings 30A and 30B are connected by welding to the end portions 23A, 23B of the inner side surface of the tubular shield member 23, respectively (a connecting process). Then, the shield member 23 is molded such that the outer layer member 21 made of rubber is formed on an entire outer surface area of the shield member and on the inner surface area of the shield member 23 excluding the portion to which the C-rings 30 are connected (an outer layer member forming process and an inner layer member forming process). With the outer layer member forming process and the inner layer member forming process, the outer layer member 21 and the inner layer member 22 are formed on the respective outer and inner surfaces of the shield member 23. Consequently, the protector 20 including such a shield member 23 and the C-rings 30 connected to the end portions 23A and 23B of the inner surface of the shield member 23 is obtained.

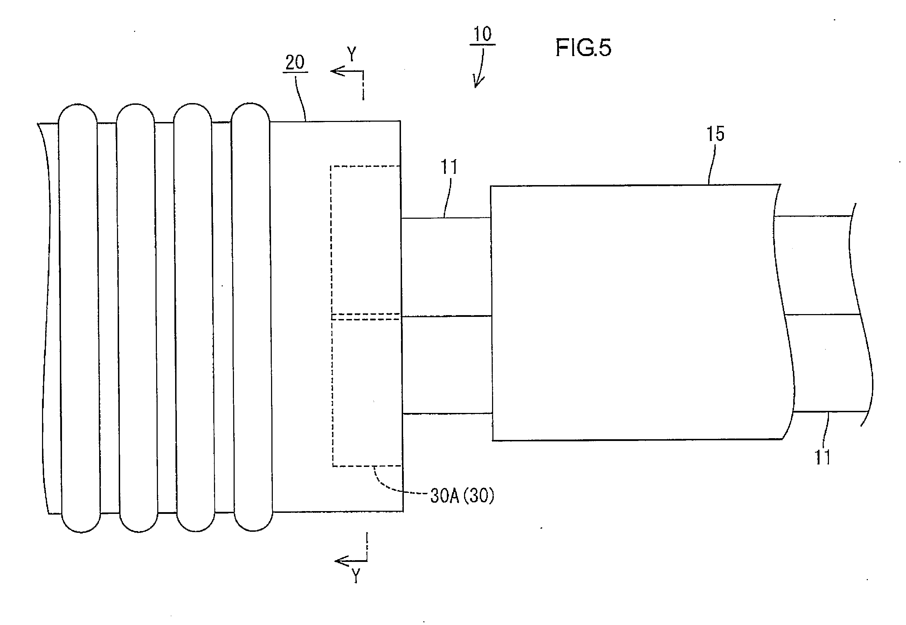

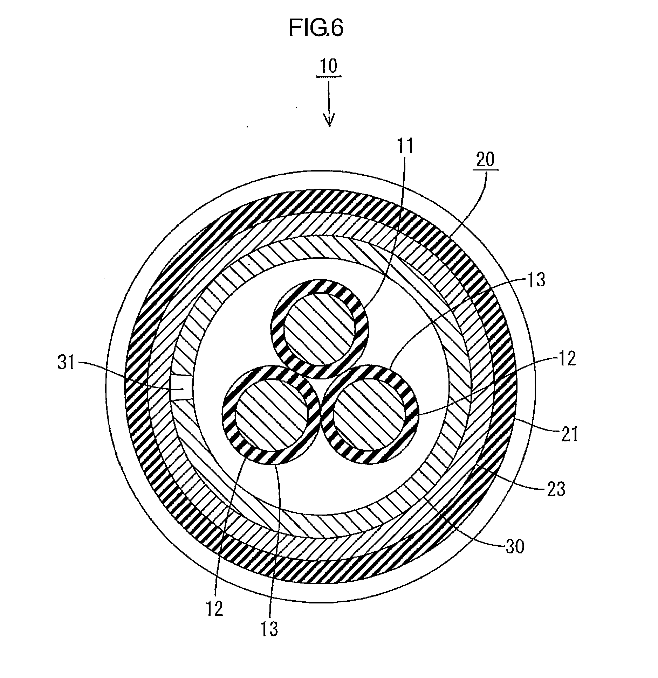

As illustrated in FIG. 5, the protector 20 obtained through the above processes is attached to the end portion of the metal pipe 15 through which the electric wires 11 are passed. Accordingly, the inner surface of the first C-ring 30A and the outer surface of the metal pipe 16 come into contact (refer to FIG. 7). FIG.6 is a cross-sectional view taken along line Y-Y in FIG. 5 and illustrates a state before the protector 20 is attached to the end portion of the metal pipe 15. The protector 20 before attaching to the end portion of the casing 16 has a similar configuration to that in illustrated in FIG. 6.

After the electric wires 11 are connected to the device arranged in the casing 16, the protector 20 is fitted to cover the end portion of the casing 16. Consequently, the protector 20 is arranged so as to extend from the end portion of the pipe 15 to the end portion of the casing 16. In this state, the outer surface of the casing 16 comes in contact with the inner surface of the second C-ring 30B. FIG. 7 illustrates a state after the protector 20 is fitted to the end portion of the metal pipe 15. The protector 20 that is attached to the end portion of the casing 16 has a similar configuration to that in illustrated in FIG. 7.

Next, a portion of the protector 20 corresponding to the first connecting portion 23A is clamped from the outer side by a jig (not illustrated). This decreases the diameter of the first C-ring 30A, and the protector 20 and the metal pipe 15 are firmly fixed to each other by the first C-ring 30A (refer to FIG. 2). Similarly, a portion of the protector 20 corresponding to the second connecting portion 23B is clamped from the outer side by a jig. This decreases the diameter of the second C-ring 30B, and the protector 20 and the casing 16 are firmly fixed to each other by the second C-ring 30B. FIG. 2 illustrates the protector 20 that is clamped to the end portion of the metal pipe 15. The protector 20 that is clamped to the end portion of the casing 16 also has a similar configuration to that in FIG. 2. In this state, the outer surface of the metal pipe 15 is securely in contact with the first C-ring 30A connected to the shield member 23, and the outer surface of the casing 16 is securely in contact with the second C-ring 30B connected to the shield member 23. Accordingly, the shield member 23 is electrically connected to the metal pipe 15 at the first connecting portion 23A and electrically connected to the casing 16 at the second connecting portion 23B.

### (Operations and effects)

The operations and the effects of the present embodiment will be explained.

In the present embodiment, the protector 20 includes the tubular outer layer member 21, the tubular flexible shield member 23, the first C-ring 30A, and the second C-ring 30B. The outer layer member 21 is arranged to extend from the end portion of the metal pipe 15 to the end portion of the casing 16 and the outer layer member is made of flexible insulation. The shield member 23 is arranged along the inner surface of the outer layer member 21 and provided integrally with the outer layer member 21. The shield member 23 is made of a conductive material and electrically connected to the metal pipe 15 and the casing 16. The first C-ring 30A is connected to the connecting portion 23A (first connecting portion 23A) of the inner surface of the shield member 23 to which the metal pipe 15 is connected. The second C-ring 30B is connected to the connecting portion 23B (the second connecting portion 23B) of the inner surface of the shield member 23 to which the casing 16 is connected. According to the present embodiment, after the protector 20 is arranged to extend from the end portion of the metal pipe 15 to the end portion of the casing 16, the portions of the protector 20 to which the C-rings 30A and 30B are connected to are clamped with using a jig. This simple operation fixes the protector 20 firmly to the metal pipe 15 and the casing 16. Further, the electric wires 11 including the connecting portion connected to the device can be protected. Furthermore, the shield member 23 that is made of a conductive material and provided integrally with the inner surface of the outer layer member 21 of the protector 20 is surely connected to the metal pipe 15 and the casing 16 via the respective C-rings 30, and this ensures each connection. Further, according to the present embodiment, the protector 20 and the C-rings 30 are connected to each other and therefore, the protector and the fixing member 30 are provided as a single member. This can reduce the number of parts.

As a result, a work of attaching a member for the electromagnetic shielding and electric wire protection can be simplified.

According to the present embodiment, the protector 20 includes the inner layer member 22 that is provided to integrally sandwich the shield member 23 with the outer layer member 21. The inner layer member 22 is arranged on the inner surface of the shield member 23 excluding the inner surfaces of the shield member 23 corresponding to the first and the second connecting portions 23A and 23B. With such a configuration, the shield member 23 is less likely to catch on the electric wires 11 or a terminal connected to the electric wires 11. Therefore, the protector 20 can be easily attached and the inner surface of the shield member 23 can be protected.

According to the present embodiment, after the C-rings 30 are connected to the inner surface of the shield member 23 in the protector 20 in the connecting process, the outer layer member forming process and the inner layer member forming process are performed to form the outer layer member 21 and the outer layer member on the respective outer and inner surfaces of the shield member 23. Therefore, masking of the shield member 23 is not necessary in manufacturing the protector 20 and thus the protector 20 is easily manufactured.

Further, according to the present embodiment, the outer layer member 21 is made of rubber. Therefore, the first connecting portion 23A is pressed to the end portion of the metal pipe 15 due to the elasticity of the outer layer member 21 and the connection between the shield member 23 and the metal pipe 15 can be secured. The second connecting portion 23B is pressed to the end portion of the casing 16 due to elasticity of the outer layer member 21 and the connection between the shield member 23 and the casing 16 can be secured. Further, according to the present embodiment, the inner layer member 22 is also made of rubber, and this ensures the connection between the protector 20 and the metal pipe 15 and the connection between the protector 20 and the casing 16.

### <Other embodiments>

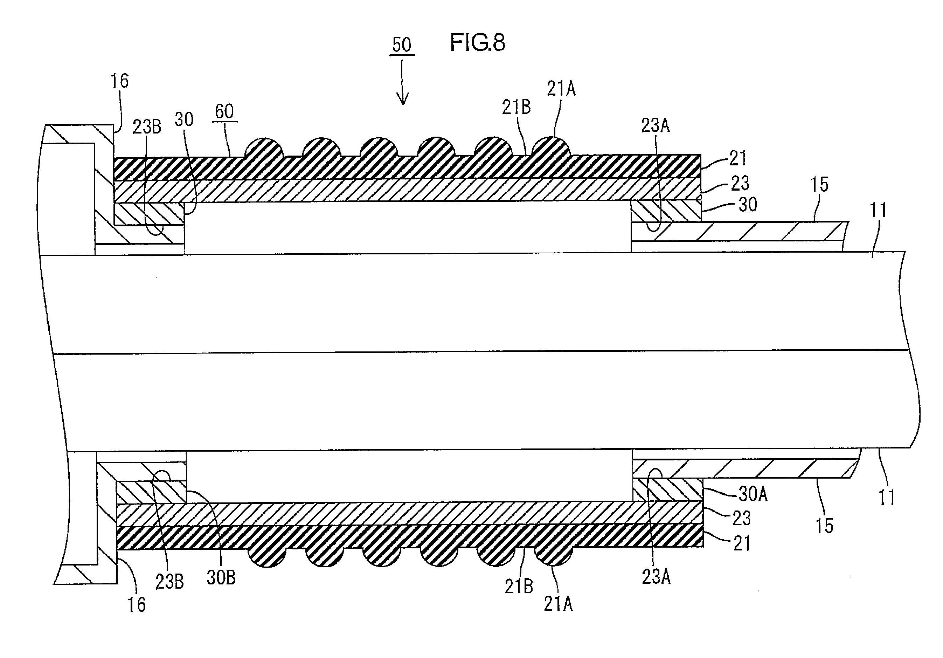

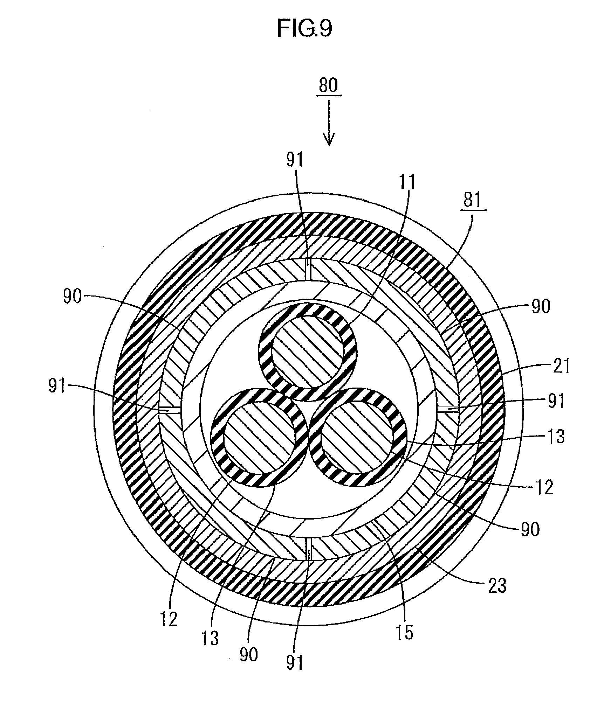

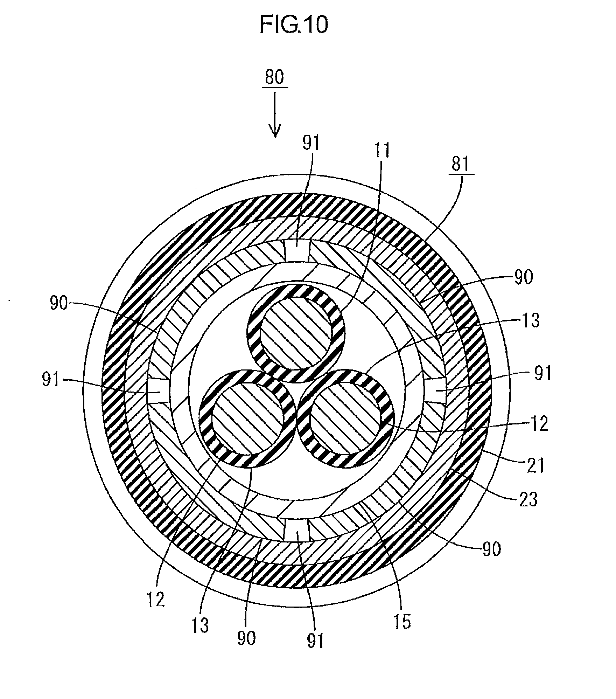

The present invention is not limited to the embodiments explained in the above description with reference to the drawings. The following embodiments may be included in the technical scope of this invention, for example.
(1) In the above embodiment, the protector 20 includes the inner layer member 22. However, the inner layer member 22 may not be included in a protector like a protector 60 illustrated in FIG. 8. A shield conductor 50 in FIG. 8 has the same configuration as the shield conductor 10 of the first embodiment except that the protector 60 does not include the inner layer member 22. In FIG. 8, the same parts as those in the first embodiment are indicated by the same symbols.
(2) In the above embodiment, the C-rings 30 are used as the fixing members. However, as illustrated in FIG. 9, a fixing member 90 including four metal pieces 90 each having an arched cross-sectional shape may be used as the fixing member.
   As illustrated in FIG. 9, a part of the shield conductor 80 corresponding to the first connecting portion to which the fixing member 90 is connected is clamped by a jig. This decreases each gap between the metal pieces 90. Accordingly, the protector 81 is firmly fixed to the metal pipe 15. Similar to the first connecting portion, the second connecting portion of the shield conductor 80, which is not illustrated, is clamped by a jig. Accordingly, each gap (the gap 91) between the metal pieces 90 is decreased and thus the protector 81 is firmly fixed to the casing 16. The shield conductor 80 in FIGS. 9 and 10 has the same configuration as the first embodiment except for the configurations of the fixing member 90. Thus, the same parts as those in the first embodiment are indicated by the same symbols.
(3) In the above embodiment, the outer and inner layer members 21 and 22 are made of rubber. However, the material may not necessarily be rubber and may be any flexible insulation materials.
(4) In the above embodiment, three electric wires 11 that are passed through the metal pipe 15 and arranged in a triangle with a sectional view are included in the shield conductor. However, the electric wires 11 may not be necessarily arranged in the above configuration. The number of the electric wires may be one, two, four, or more. Further, the electric wires may be arranged to be flat or in a square with a sectional view.

### EXPLANATION OF SYMBOLS

10, 50, 80··· shield conductor
11··· electric wire
15··· metal pipe
16··· casing
20, 60, 81··· protector
21··· outer layer member
22··· inner layer member
23··· shield member
23A, 83A··· first connecting portion
23B··· second connecting portion
30, 90··· fixing member
30A··· first C-ring (first fixing member)
30B··· second C-ring (second fixing member).

## Claims

1. A tubular protector protecting an electric wire that is surrounded by a metal pipe and connected to a device provided in a casing, the protector protecting a portion of the electric wire extending from an end portion of the metal pipe to an end portion of the casing, the protector comprising:
a tubular outer layer member arranged to extend from an end portion of the metal pipe to an end portion of the casing, the outer layer member being made of flexible insulation;
a tubular flexible shield member arranged along an inner surface of the outer layer member and provided integrally with the outer layer member, the shield member being made of a conductive material and configured to be electrically connected to the metal pipe and the casing; and
one or more fixing members selected from a first fixing member and a second fixing member,
the first fixing member connected to a first connecting portion of an inner surface of the shield member to which the metal pipe is to be connected, the first fixing member being configured to fix the protector and the metal pipe and to establish electrical connection therebetween, and
the second fixing member connected to a second connecting portion of the inner surface of the shield member to which the casing is to be connected, the second fixing member being configured to fix the protector and the casing and to establish electrical connection therebetween.

2. The protector according to claim 1, further comprising:
a tubular inner layer member made of flexible insulation and provided on an inner surface of the shield member excluding parts of the inner surface of the shield member corresponding to the first connecting portion and the second connecting portion, the inner layer member and the outer layer member sandwiching the shield member so as to be integral with each other.

3. The protector according to claim 1 or 2, wherein the outer layer member is made of rubber.

4. The protector according to claims 2 or 3, wherein the inner layer member is made of rubber.

5. A method of manufacturing a tubular cable protector protecting an electric wire that is surrounded by a metal pipe and connected to a device provided in a casing, the protector protecting a portion of the electric wire extending from an end portion of the metal pipe to an end portion of the casing, the method comprising:
connecting a fixing member to one or more portions selected from a first connecting portion and a second connecting portion of an inner surface of a tubular shield member, the fixing member having conductivity and being configured to fix the protector to one or more members selected from the metal pipe and the casing, the shield member having flexibility and being made of a conductive material, the first connecting portion being configured to be electrically connected to the metal pipe, the second connecting portion being configured to be electrically connected to the casing; and
forming an outer layer member on an outer surface of the shield member, the outer layer member being made of an insulation material.

6. The method of manufacturing the protector according to claim 5, further comprising:
forming an inner layer member along a part of the inner surface of the shield member excluding the first and the second connecting portions, the inner layer member being made of an insulation material.

7. The method of manufacturing the protector according to claim 5 or 6, wherein the outer layer member is formed with rubber.

8. The method of manufacturing the protector according to claim 6 or 7, wherein the inner layer member is formed with rubber.

9. A shield conductor comprising:
the protector according to any one of claims 1 to 4;
the electric wire configured to be connected to the device provided in the casing; and
the metal pipe surrounding the electric wire.

10. A shield conductor comprising:
the protector manufactured by the method according to any one of claims 5 to 8;
the electric wire configured to be connected to the device provided in the casing; and
the metal pipe surrounding the electric wire.
